# EUROPEAN PATENT SPECIFICATION

(11) **EP 3 388 849 B1**
(45) Date of publication and mention of the grant of the patent: **08.06.2022**
(21) Application number: 17401042.1
(22) Date of filing: 11.04.2017
(51) Int. Cl.: G01R 31/303, G11C 29/00, G01R 1/07, G11C 29/32, G11C 29/56

(54) **MAGNETIC PROBE BASED TEST METHOD FOR SPINTRONIC TECHNOLOGIES**
AUF MAGNETSONDE BASIERENDE PRÜFVERFAHREN FÜR SPINTRONIC TECHNOLOGIE
PROCÉDÉ DE TEST POUR LA TECHNOLOGIE SPINTRONIC EN UTILISANT UN SONDE MAGNETIQUE

(43) Date of publication of application: 17.10.2018
(73) Proprietor: Karlsruher Institut für Technologie, 76131 Karlsruhe (DE)
(72) Inventor: Oboril, Fabian, 76139 Karlsruhe (DE); Bishnoi, Rajendra, 76676 Graben-Neudorf (DE); Tahoori, Mehdi B., 76227 Karlsruhe (DE)

(56) References cited:
- US-A1- 2016 104 502
- US-A1- 2017 059 669
- US-B2- 7 165 197

## Description

The technical field of this application addresses the issue of testing on a "System on chip" (SoC). More detailed herein a magnetic probe based test method for spintronic technologies is disclose.

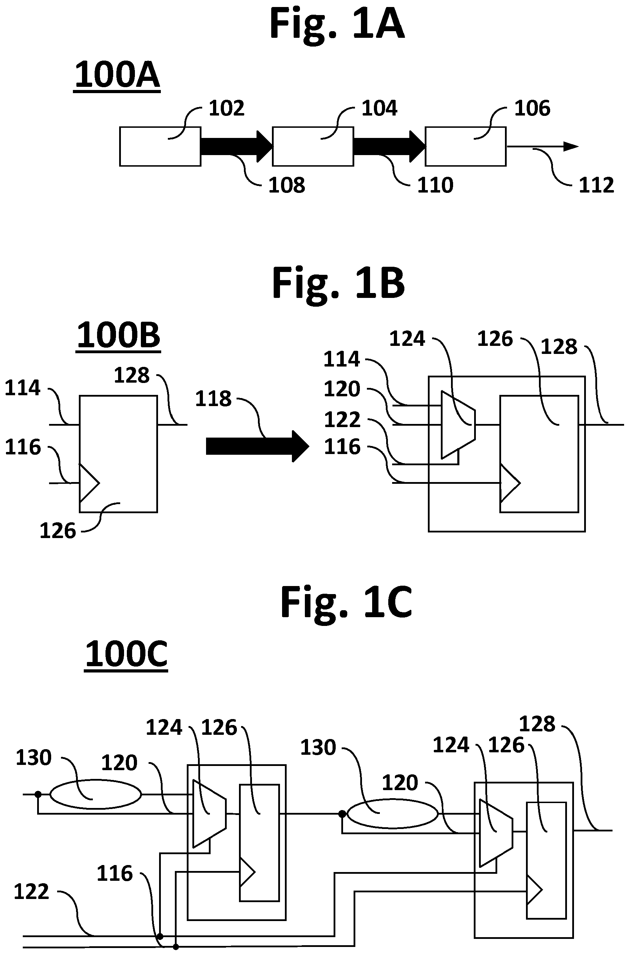

With technology downscaling, the increase in transistors count and functionalities per chip increases the chip testing complexity significantly. This is because, smaller devices in a very dense design environment can easily lead to a defective devices or interconnections. Defects are usually caused due to a random localized imperfection during manufacturing processes, resulting in improper via's, resistive bridges, resistive open, etc. A state-of-the-art, basic test method is shown in Fig. 1A. The problem of conventional test methods is that the test-data is propagated serially, hence overall it is very time consuming method.

According to the present invention herein, a test method is disclosed for a SoC where parallel test-data are accessible, and hence, the test time can be reduced significantly.

Herein cited literature:
[1] *"*CMOS VLSI Design: A Circuit and System Perspective", from Neil H.E. Weste and David Harris, Third Edition, Addison Wesley, Chapter 9, Page 596 (2004), ISBN-10: 0321149017, ISBN-13: 978-032114901.
[2] R. Bishnoi, F. Oboril, and M.B. Tahoori. "Fault Tolerant Non-Volatile Spintronic Flip-Flop", published in DATE conference, pages 261-264 (2016).
[3] R. Bishnoi, F. Oboril, and M.B. Tahoori. "Non-Volatile Non-Shadow Flip-Flop using Spin Orbit Torque for Efficient Normally-off Computing", published in ASPDAC conference, pages 769-774 (2016).
[4] R. Robertazzi, I. Nowak, and I. Sun. "Analytical MRAM test", published in ITC conference, pages 1-10 (2014).
[5] US 2016/104502 A1 discloses a magnetic memory system for storing information with laser recording.

Scan-chain design is the most commonly adopted testing method in design for testability, in which several storage elements such as flip-flops, are connected together in the form of shift-registers. In this case, these flip-flops are replaced with a flip-flop and a mux (with two additional inputs, i.e. test input and test enable), as illustrated in Fig. 1B. The testing of a design normally works at a low clock frequency.

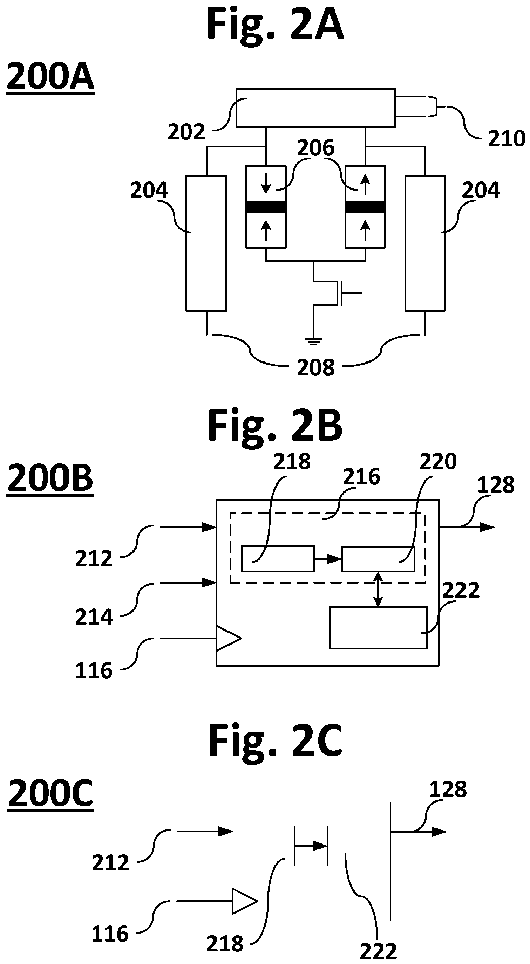

As illustrated schematically in Figs. 2A, 2B and 2C the claimed probe-based testing method is generic and thus applicable to at least these shown conventional flip-flop architectures, but not restricted to these shown examples. Fig. 2C is one of the type of the non-volatile flip-flop architecture, which consists of mainly two parts: CMOS-latch part and non-volatile latch part. Here, CMOS-latch part acts as pseudo-master latch and non-volatile latch acts as pseudo-slave latch for the flip-flop architecture. In this architecture, MTJ cells are employed as active components. This enables normally-off computing by allowing very aggressive power gating for both short and long standby periods.

The operation of such a flip-flop architecture as shown in Fig. 2C can be described in details as follows. In such architecture, the read and write operation of the non-volatile latch work at the two different levels of the clock signal. The write process to the non-volatile latch component is initiated at the same time when the input latched value is transferred to the output ports. On the other hand, the value is read out of the non-volatile latch at the next clock level and at the same time, the new value is also latched in the CMOS-latch that is ready for the next write operation.

Non-volatile flip-flops, i.e. especially spintronics based, are very attractive solution to reduce static power in a SoC. In spintronics based magnetic flip-flops, Magnetic Tunnel Junction (MTJ) cells are used as storing devices, in which values are stored as a resistance state. These storing devices require a write mechanism by providing a bidirectional current path and sensing scheme to read an MTJ value using a unidirectional current path. The block diagram for a non-volatile latch using read and write components are shown in Fig. 2A. The non-volatile latch component can be used in two ways:
1) As a backup in a shadow flip-flop architecture (as shown schematically in Fig. 2B),
   and
2) As a pseudo slave latch in a non-shadow architecture (as shown schematically in Fig. 2C).

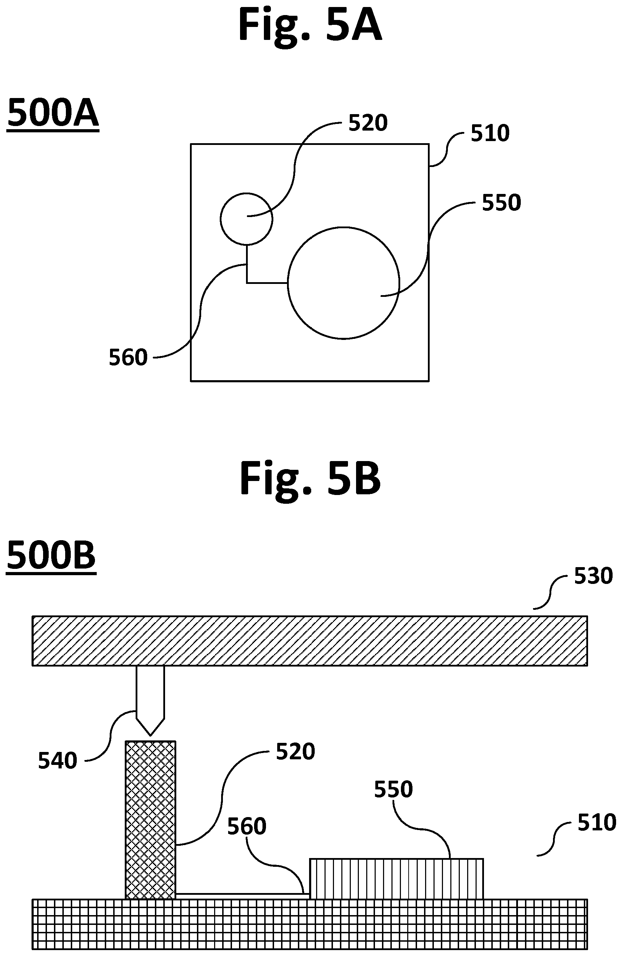

A shadow flip-flop architecture consists of a master latch, a slave latch and a non-volatile latch [2]. Here, the master and slave latches are same as in conventional CMOS flip-flop. It behaves as a conventional flip-flop during normal operation and the data is stored to the non-volatile latch when power down mode is activated. The dedicated pin (PD in Fig. 5) is allocated to activate this operation and once the data is stored in the non-volatile latch, the power supply is disconnected for static power reduction. Furthermore, during wakeup, the non-volatile shadow latch content is read and re-stored back into the slave latch, so that the normal operation can be resumed. Non-shadow non-volatile flip-flop architecture consists of a CMOS latch and a non-volatile latch [3]. Here, the non-volatile latch is the active element of the flip-flop that means the data can be stored and read in every single operating clock cycle.

Magnetic digital testers are available currently in the market that are extensively used for the MRAM test system. For example, Vergy 93K C200e digital tester, which is capable of operating in both logic and memory mode.

It is an object of the present invention to provide a Magnetic Probe Based Test Method for Spintronic Technologies which reduces the testing time.

Said object is achieved by the method according to the subject matter of the independent claims. Dependent claims relating to these represent advantageous embodiments. Advantageous further developments, which can be implemented individually or in any desired combination, are shown in the dependent claims.

In the following, the terms "comprise", "include", "enclose", "involve" or any grammatical variations thereof are used in a non-exclusive manner. Accordingly, these terms may refer to situations in which, in addition to the features introduced by these terms, no further features are present, or to situations in which one or more further features are present. For example, the expression "A has B", "A comprises B", or "A includes B" may refer to the situation where, apart from B, there is no further element present in A (i.e., in which A consists exclusively of B), as well as to the situation in which, in addition to B, one or more further elements are present in A, for example element C, elements C and D or even further elements.

Further, it is noted that the terms "at least one" and "one or more" as well as grammatical variations of these terms, when used in conjunction with one or more elements or features, are intended to express and express the element or feature in a single or multiple manner Can only be used once, for example, during the initial introduction of the feature or element. In the case of a subsequent renewed mention of the feature or element, the corresponding term "at least one" or "one or more" is generally no longer used without restricting the possibility that the feature or element may be provided in a single or multiple manner.

Furthermore, in the following, the terms "preferably", "in particular", "for example", "for instance", "by the way of example", or similar terms are used in conjunction with optional features, without thereby restricting alternative embodiments. Thus, features introduced by these terms are optional features, and it is not intended to limit the scope of the claims and particularly the independent claims by these features. Thus, as will be recognized by those skilled in the art, the invention can also be carried out using other embodiments. Similarly, features introduced by "in one embodiment", or "in another embodiment" are understood to be optional features, without thereby limiting alternative embodiments or the scope of the independent claims. Furthermore, by means of these introductory expressions, all possibilities to combine the introduced features with other features, whether optional or non-optional features, should be remained intact.

A first embodiment, which is disclosed in claim 1 is a method for testing at least one electronic assembly.

A further embodiment discloses a method wherein said electronic assembly further comprises at least m logic gates, wherein m is a natural number starting with 0, corresponding to non-negative integers, i.e. m = 0, 1, 2, 3, ...; and wherein at least one of said magnetic storage cells and one of said logic gates provides at least one electrically conductive connection.

A further embodiment discloses a method wherein all said magnetic storage cells are written by means of said testing device with a first test data set wherein said electronic assembly is triggered subsequently to operate for at least one single system clock pulse; and wherein all said magnetic storage cells are read out subsequently by means of said testing device. Definitions of herein used genera:

### - Electronic assembly:

Electronic assembly describes a collection of all electronic components such as logic gates, magnetic storage cells, and testing devices. In other words, all components of a system-on-chip and their testing environment are placed on a single platform to perform a certain operation. The testing environment typically consists of design-under-test (= DUT), probe-card, load-board, and tester (with RAM associated with each pin).

### - Magnetic storage device:

These are Magnetic Tunnel Junction (= MTJ) cells, the storing devices in spintronic technology. Here, values are stored in terms of resistance states. The MTJ cell comprises or is made of at least two ferromagnetic layers (e.g. CoFeB) separated by at least one thin barrier oxide layer (e.g. MgO). One of the two ferromagnetic layers has always fixed magnetic orientation, known as fixed layer (or referenced layer). While the magnetic orientation of the other layer can be freely rotated, known as free layer. The magnetic orientation of the free layer can be rotated either using external magnetic field or by passing a polarized current through the device. When the direction of the magnetic orientation of the free layer parallel to the fixed layer, the device has a low resistance value. On the other hand, when the magnetic orientation of the free layer anti-parallel to the fixed layer, the device has a high resistance value.

### - Testing device:

In general, testing process is started when the fabrication of the chip is completed. For the testing process, a tester, a test fixture and a test program is required. A tester is employed to apply a sequence of stimulus to the fabricated chip (which is the design-under-test [= DUT]) and monitor their responses. The test fixture consists of a probe card, a load board and a printed circuit board (PCB). A probe card and a load board are used to test the chip at wafer-level and package-level, respectively. Moreover, the test programs, that are used by the tester and written in high-level programing language, specify a set of input patterns and observers their responses. The tester would report an error if any mismatch found.

### - Read / write electronics:

Both read and write mechanisms are associated with the storing system like random access memories (or simply RAM). Accessing any storage system to know its content is known as read operation. On the other hand, accessing any storage system to change its content is known as write operation. In general, specific read and write components are required to perform their respective operation. For instance, a sense amplifier and a write circuitry are required for read and write operations in RAM, respectively. These read and write operations can also be performed using magnetic probes in testing phase (or before packaging).

### - Electrically conductive connection:

Two or more objects are connected each other that allows the flow of electron current to perform a definite function. Objects can be logic gates, transistors, magnetic storage cells, resistors, capacitors, etc. These connections are done through semiconductor routing wires. Connections can be made using contacts or vias between objects or routing wires. These connections can be local or global depending on the hierarchy of the design. In hierarchical design system, several small objects are connected each other and make a design block, and such design blocks are connected each other makes a bigger design block and so on. The connections inside a design block is known as local connection to that block, whereas the connections among design blocks are termed as global connections.

### - System clock pulse:

Clock is a signal that oscillates between a low state and a high state (repetitive events in terms of cycles). In synchronous system, the execution of the applications are performed with respect to a clock. In other words, every operation in a synchronous system is performed using a clock signal to distinguish one step in computation from the next or previous step. The clock period is the duration time of one cycle. I.e. sum of a low state and a high state of the clock. This is the inverse of the clock frequency of the system. In general clocking system has two part:
1) Functional clock, with which the real applications are executed, and
2) Test clock, with which testing is done.

In general, the testing clock pulse is longer than that of the functional clock cycle.

### - Clk (= abbreviation: Clock):

In a synchronous system, clocked elements such as latches, flip-flops, registers, memories are controlled using Clk signal (or Clock signal). This signal is one of the inputs to these clocked elements. Internally all functions are regulated based on the level of this Clk signal. For an example, the sequence of operations in a state machine is controlled using the clock signal in a time domain manner. The clock signal is generated by a clock-generator and depending on the design, this clock can be divided into several other clocks, known as derived clock signals.

### - Mux:

A Mux (full form is multiplexer) is a device which has 2n inputs, n select lines and one output. Depending on the select lines, one of the input line data is propagated to the output line. Therefore, multiplexors are also known as data selectors. Consider an example of an 8-to-1 mux, it has total 8 inputs, 3 select line and one output. Multiplexer designs are extensively used in communication system applications.

### - Q or Test-Output:

In general, the letter "Q" can be used for a cell level output value (at design-level). For a complete block (or system) output value, we need to use a specific term for that. For instance, the output of a test block can be represented as "Test-Output". The out of a system is generated based on the input value (or values) and its functionality. In order to test the functionality of a design block, a sequence of input data is provided to the system and its test-out data is observed. The test-output-data is compared with the expected data to generate the final result, i.e. test pass or fail.

### - Non-volatile latch / flip-flop:

In electronics, a flip-flop or latch is a circuit that has two stable states and can be used to store state information. A flip-flop is a bistable multivibrator. The circuit can be made to change state by signals applied to one or more control inputs and will have one or two outputs. It is the basic storage element in sequential logic. Flip-flops and latches are fundamental building blocks of digital electronics systems used in computers, communications, and many other types of systems.

Flip-flops and latches are used as data storage elements. A flip-flop stores a single bit (binary digit) of data; one of its two states represents a "one" and the other represents a "zero". Such data storage can be used for storage of state, and such a circuit is described as sequential logic. When used in a finite-state machine, the output and next state depend not only on its current input, but also on its current state (and hence, previous inputs). It can also be used for counting of pulses, and for synchronizing variably-timed input signals to some reference timing signal. Flip-flops can be either simple (transparent or opaque) or clocked (synchronous or edge-triggered). Although the term flip-flop has historically referred generically to both simple and clocked circuits, in modern usage it is common to reserve the term flip-flop exclusively for discussing clocked circuits; the simple ones are commonly called latches. Using this terminology, a latch is level-sensitive, whereas a flip-flop is edge-sensitive. That is, when a latch is enabled it becomes transparent, while a flip flop's output only changes on a single type (positive going or negative going) of clock edge.

### - CMOS:

Complementary metal-oxide-semiconductor, abbreviated as CMOS, is a technology for constructing integrated circuits. CMOS technology is used in microprocessors, microcontrollers, static RAM, and other digital logic circuits. CMOS technology is also used for several analog circuits such as image sensors (CMOS sensor), data converters, and highly integrated transceivers for many types of communication. CMOS is also sometimes referred to as complementary-symmetry metal-oxide-semiconductor (or COS-MOS). The words "complementary-symmetry" refer to the fact that the typical design style with CMOS uses complementary and symmetrical pairs of p-type and n-type metal oxide semiconductor field effect transistors (MOSFETs) for logic functions. Two important characteristics of CMOS devices are high noise immunity and low static power consumption.[3] Since one transistor of the pair is always off, the series combination draws significant power only momentarily during switching between on and off states. Consequently, CMOS devices do not produce as much waste heat as other forms of logic, for example transistor-transistor logic (TTL) or NMOS logic, which normally have some standing current even when not changing state. CMOS also allows a high density of logic functions on a chip. It was primarily for this reason that CMOS became the most used technology to be implemented in VLSI chips. The phrase "metal-oxide-semiconductor" is a reference to the physical structure of certain field-effect transistors, having a metal gate electrode placed on top of an oxide insulator, which in turn is on top of a semiconductor material. Aluminum was once used but now the material is polysilicon. Other metal gates have made a comeback with the advent of high-k dielectric materials in the CMOS process, as announced by IBM and Intel for the 45 nanometer node and beyond.

### - PD (abbreviation for Power Down):

During the standby-mode or sleep-mode, a system (or any design block) doesn't perform any operation. During this period of time, no dynamic energy is consumed, nevertheless, the static power is consumed in the form of leakage current. The best way to reduce static power is to turn-off (or reduce) the power supply, and this process is known as power-down. For many design blocks, an input pin can also be named as power-down (or simple PD), means when this signal is activated, the subsequent action of operation (i.e. copying of relevant data) is initiated. In a shadow flip-flop architecture, as shown in Fig 2-b, also has a pin named PD that indicates that when this pin is activated the content of the conventional CMOS flip-flop data is coped to the non-volatile latch. The data is restored back to the conventional CMOS flip-flop on the deactivation of this PD pin signal.

### - MTJ_read

Represents a process to access the MTJ cell to obtain its content. The MTJ cell can be read by passing a small unidirectional current through it, which is sensed using a sense amplifier. The MTJ cell stores the value in term of resistance states by the means of relative magnetic orientation of their ferromagnetic layers. During the design time, a sensing mechanism is activated to read the MTJ cell that passes a current through the MTJ cell and whose resistance value is then compared with the reference resistance value in order to know the final output value as stored in the MTJ cell. During the testing time, a similar mechanism is performed using test probes.

All said magnetic storage cells are written by means of said testing device with a first test data set; wherein said electronic assembly is triggered subsequently to operate for at least one single system clock pulse; and wherein all said magnetic storage cells are read out subsequently by means of said testing device.

Following challenges associated with the conventional scan chained design for testability approach:
1) Data are propagated serially, hence time-consuming method.
2) Requires additional hardwares as well as significant routing area in a SoC design.
3) High switching activity can lead to severe thermal issues during testing.
4) Several power and timing related unrealistic problems can occur during test mode of operation. This eventually miscalculate the yield evaluation, i.e. the design is overstressed that it generates failures, however, in reality they are not.
5) Highly sophisticated and costly testing (approximately 70 % of total cost) method.
6) Acceleration of testing cycles because the complete testing can be carried out within a single system clock pulse.

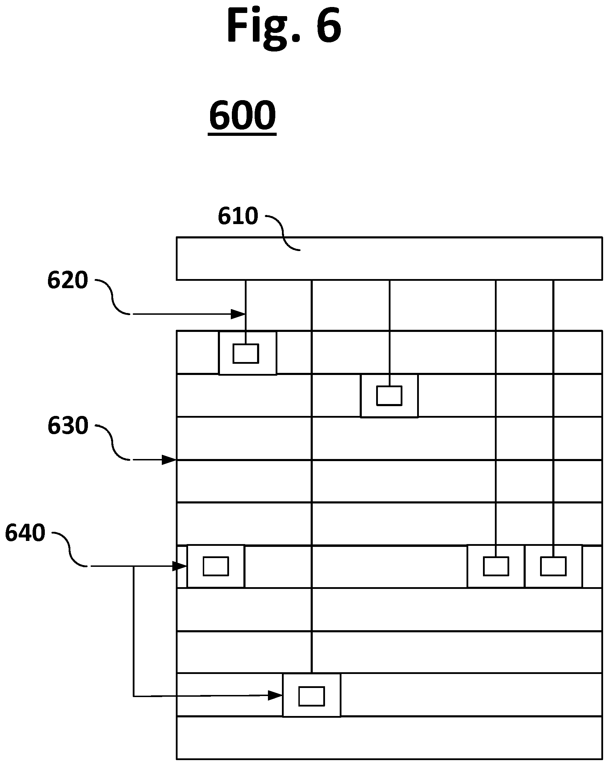

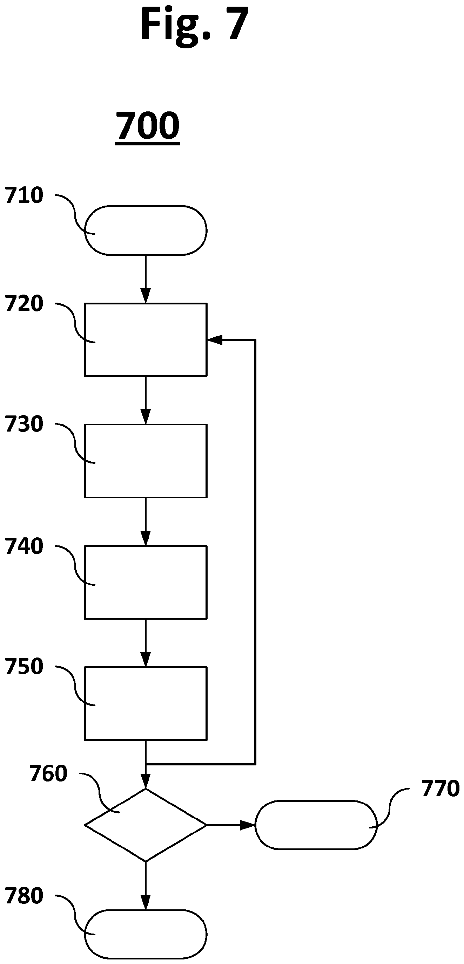

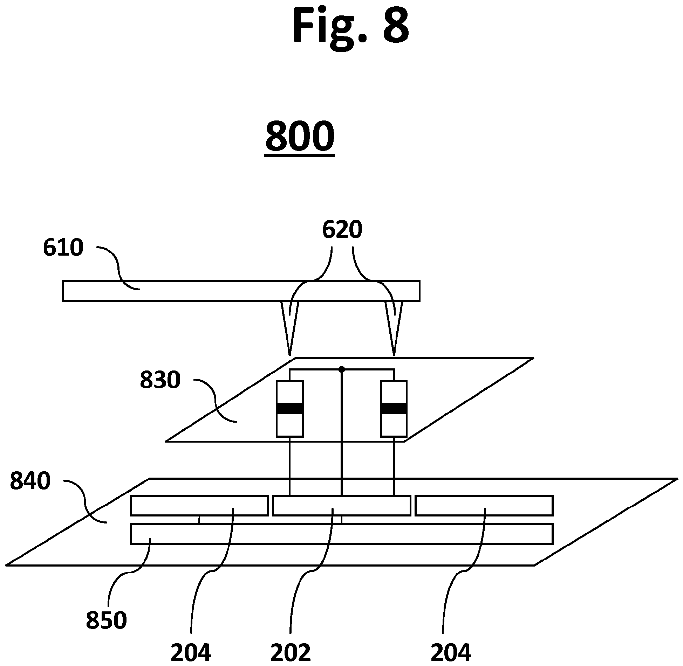

The herein disclosed method is explained as follows (following description refers to schematic flowchart as shown in Fig. 7):
A typically SoC has several flip-flops and each flip-flop has a non-volatile latch depending on the low power requirements. As shown in Fig. 2A, it consists of at least two MTJs and these two MTJs should always store opposite value due to the requirement of sensing mechanism. During the testing, the magnetic probe can be adjusted for these MTJs in order to configure the required value (in terms of magnetic orientations) by creating an appropriate magnetic field, as shown in Fig. 6 and Fig. 8. Here, representative MTJs are necessary to define, i.e. one of the MTJs with P magnetization represents 1 or vice-versa, which can be identified using color coding in a SoC during testing. Once the value is stored in the MTJs, it has to be propagated to the MTJ of the next flip-flop, from where it has to be read. These transfer of data between two flip-flops or MTJs and logics can be performed by applying clock and other necessary signals. The read out value by sensing the magnetization of the MTJ's through the probes, is then compared it with the golden one. If the final result matches with that of the golden, it passes otherwise it fails. The disclosed test Method enables to cover both hardware and software parts. For hardware, the disclosed method enables to adjust the probing mechanism in such a way that parallel access MTJs is enabled (unlike serially in conventional approach), as shown in Fig. 8. For software part, the disclosed method enables to arrange the controlling mechanism (as described e.g. by the flowchart shown in Fig. 8) to support the faster test processing such as providing data input stream, comparison with reference value, etc. This is because data is accessed parallel using hardware components and the new data is available in a very less interval of time.

### Description of the figures

Further details and features of the present invention result from the following description of an embodiment, in particular in connection with the dependent claims. In this case, the respective features may be realized on their own or in a plurality in combination with one another. The invention is not limited to these embodiments.

The embodiments are schematically illustrated in the following figures. Here, the same reference numerals in the figures denote the same or functionally equivalent elements or elements corresponding to one another in terms of their functions.

Herein the following figures show in:
- **Fig. 1A-C**: schematic representations of the state of the art;
- **Fig. 2A-C**: schematic representations of the state of the art;
- **Fig. 3**: scheme of an embodiment of a method according to claim 1;
- **Fig. 4**: scheme of an embodiment of a method according to claim 3;
- **Fig. 5A**: schematic top view of an embodiment of devices according to one of the claims;
- **Fig. 5B**: schematic cross-section of an embodiment of devices according to one of the claims;
- **Fig. 6**: schematic cross-section of an embodiment of a device to carry out the method according to one of the claims,
- **Fig. 7**: schematic flowchart of an embodiment of a method according to one of the claims; and
- **Fig. 8**: a magnified schematic representation of Fig. 6, i.e. schematic representation of an embodiment of devices to carry out the method according to one of the claims.

### Detailed description

**Figs. 1A-C** **and** **Figs. 2A-C** show schematically embodiments of the state of the art as already described above. The state-of-the-art testing approaches **104** (as observed in Figures 1A-C) are very time consuming because the test patters are provided and observed in a sequential manner. For instance, in scanned-chain approach, during the testing mode, the sequence of binary values **108** are applied one by one to the input **102** of the design-under-test **104,** that are analyzed **106** one by one at the respective output port **110** of the same design-under-test **104.** The final result **112** is obtained after analysis which is either fail or pass. In this approach, several test clock cycles (depending on the number of flip-flops connected to the chain) are required to finish just one set of test pattern. A large number of such set of test patterns are typically applied to a design-under-test for a rigorous and high coverage testing. Additionally, these testing approaches are propagated through the flip-flop design **100B.** Fig. 1B shows the conventional flip-flop block that has data input **114** and clk **116** signals are inputs and Q **128** is the output. The data_input **114** signal is the applied value that is going to be stored and clk **116** signal is for the synchronization of the data storage. The Q **128** is the output data which is propagated when a clock is applied. This general flip-flop architecture is replaced with **118** a scan-chained flip-flop design which is the most commonly adopted testing method in design for testability, in which several storage elements such as flip-flops, are connected together in the form of shift-registers. In this case, these flip-flops **126** are replaced with a flip-flop **126** and a mux **124** (with two additional inputs, i.e. test input 120 and test enable **122),** as illustrated in Fig. 1B. The test input **120** is the input value that is applied during the testing process, whereas test enable **122** signal is to activate the test mode so that the test input **120** data is transferred to the output Q **128** instead of the actual design data **114.** This test enable **122** signal is connected to the select signal of the mux **124.** The output Q **128** is connected to the test input **120** of the next scanned chain flip-flop as depicted in Fig. 1C. As shown in this figure, the actual design input data **114** is propagated through some combinational logics **130.** These combinational logics 130 are the set of standard cells such as nand, nor, or, inverter, etc., based on certain design behavior. On the other hand, the test input **120** signal bypass these combinational logics **130** as shown in the figure. The testing of a design normally works at relatively lower clock frequency compared to the normal design clock frequency.

This testing method can also be applied to the non-volatile flip-flop architectures **100B** (as illustrated by Fig. 2A C), where magnetic storing devices such as STT or SOT based MTJ cells **206** are employed. On the other hand, the test method, according to the claimed invention, the test patterns **114** (both data applied as well as observed) are accessed in parallel, i.e. simultaneously, using a magnetic probe, that requires a few test clock cycles **116** (e.g. about one or two) to complete a set of test pattern. Therefore, a large number of test cycles are saved with this claimed approach, hence the total test time can be reduced significantly. The details of the herein disclosed approach explained in the following:
Non-volatile flip-flops, i.e. especially spintronics based, are very attractive solution to reduce static power in a SoC. In spintronics based magnetic flip-flops, Magnetic tunnel Junction (MTJ) **206** cells are used as storing devices, in which values are stored as a resistance state. These storing devices require a write mechanism using write components **204** by providing a bidirectional current path and sensing scheme using read components **202** to read an MTJ value by passing a unidirectional current. The block diagram for a non-volatile latch using read **202** and write **204** components are shown in Fig. 2A. The non-volatile latch component can be used in two ways:
1) As a backup in a shadow flip-flop architecture (as shown in Fig. 2B), and
2) As a pseudo slave latch in a non-shadow architecture (as shown in Fig. 2C).

A shadow flip-flop architecture consists of a master latch **218,** a slave latch 220 and a non-volatile latch **222** [2]. The master latch **218** usually first store the value to one level of clock (or clk) **116** and propagated to the output Q **128** and the slave latch **220** during next level of the clock. Here, the master **218** and slave **220** latches are same as in conventional CMOS flip-flop **216.** It behaves as a conventional flip-flop **216** during normal operation and the data **212** is stored to the non-volatile latch **222** when power down mode is activated. There is dedicated pin (PD **214** in Fig. 5) is allocated to activate this operation and once the data is stored in the non-volatile latch **222,** the power supply is disconnected for static power reduction. Furthermore, during wakeup, the non-volatile shadow latch content is read and re-stored back into the slave latch **220,** so that the normal operation can be resumed. Non-shadow non-volatile flip-flop architecture consists of a CMOS latch and a non-volatile latch [3]. Here, the non-volatile latch **222** is the active element of the flip-flop **126** that means the data 212 can be stored and read in every single operating clock cycle. Fig. 2C is such non-volatile flip-flop architecture, which consists of mainly two parts: CMOS-based master latch **218** part and non-volatile latch **222** part. Here, non-volatile latch **222** acts as pseudo-slave latch for the flip-flop architecture. In this architecture, MTJ **206** cells are employed as active components. This enables normally-off computing by allowing very aggressive power gating for both short and long standby periods.

The operation of such a flip-flop architecture, as shown in Fig. 2C, can be described in details as follows. In such architecture, the read and write operation of the non-volatile latch **222** work at the two different levels of the clock **116** signal. The write process to the non-volatile latch **222** component is initiated using write components **204** at the same time when the input latched value is transferred to the output ports. On the other hand, the value is read out of the non-volatile latch **222** using read component **202** at the next clock level and at the same time, the new value is also latched in the CMOS based master latch **218** that is ready for the next write operation.

As illustrated schematically in Figs. 2A, 2B and 2C the claimed probe-based testing method is generic and thus applicable to at least these shown non-volatile flip-flop architectures, but not restricted to these shown examples. Magnetic digital testers are available currently in the market that are extensively used for the MRAM test system. For example, Vergy 93K C200e digital tester, which is capable of operating in both logic and memory mode.

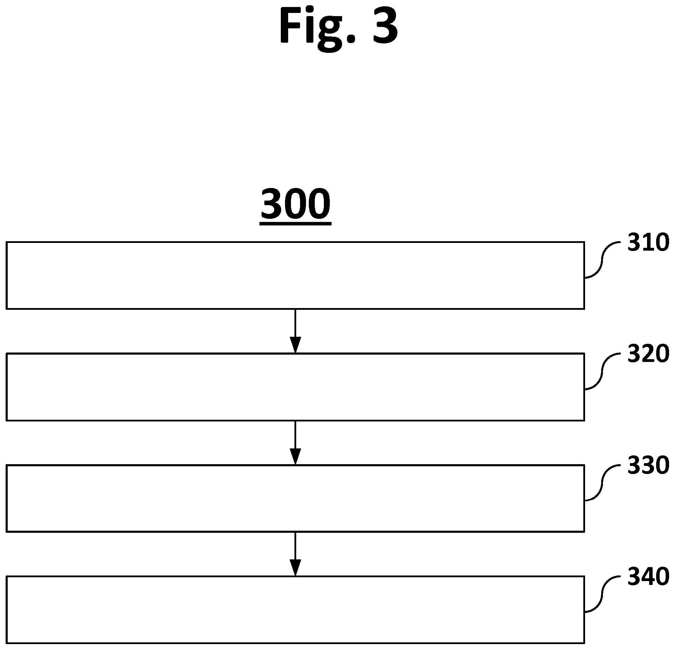

**Fig. 3** shows a scheme of an embodiment of a method **300** for testing at least one electronic assembly, comprising: providing at least one electronic assembly, wherein said electronic assembly comprises at least n magnetic storage cells, and wherein n is a natural number starting with 1, corresponding to positive integers, i.e. n = 1, 2, 3, ...; and at least one testing device with n read write electronics, wherein said read-write electronics are adapted to said at least one said storage cell **310;** arranging said testing device above said electronic assembly so that each of said read-write electronics is located without contact on top of one respective storage cell **320;** writing at least one of said storage cells **520** by means of said testing device **330;** and reading out at least said storage cell **320** by means of said testing device **340.**

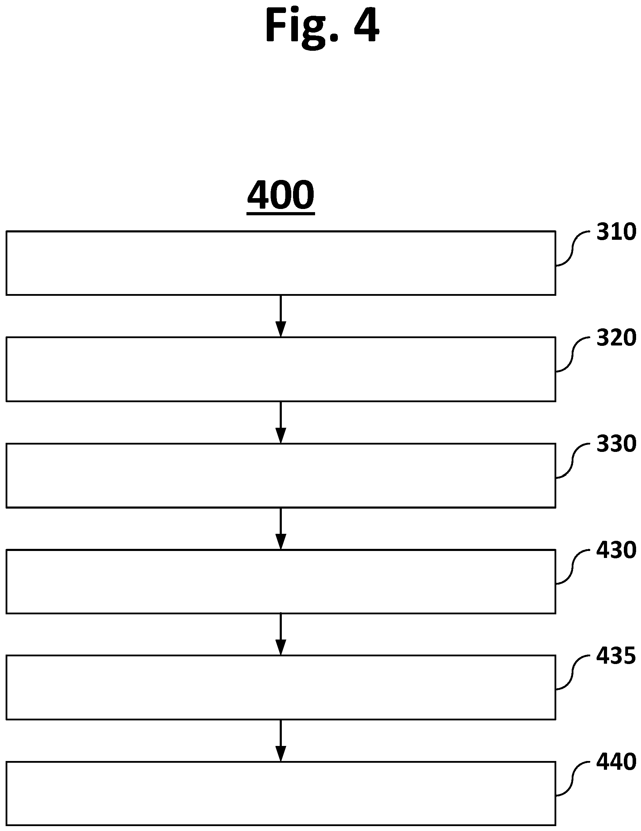

**Fig. 4** shows scheme of an embodiment of a method **400,** based on method 300 described above, wherein said electronic assembly further comprises at least m logic gates, wherein m is a natural number starting with 0, corresponding to non-negative integers, i.e. m = 0, 1, 2, 3, ...; and wherein at least one of said magnetic storage cells and one of said logic gates provides at least one electrically conductive connection. Furthermore, method **400** comprises further at least the following steps: writing all said magnetic storage cells by means of said testing device with a first test data set **430;** triggering subsequently said electronic assembly to operate for at least one single system clock pulse **435;** and reading out all subsequently said magnetic storage cells **440.**

**Fig. 5A** shows a schematic top view of an embodiment **500A** of devices according to the claimed invention in this present application. The embodiment **500A** of devices comprises at least an electronic assembly **510** comprising at least one magnetic storage cell **520** and at least one logic gate, wherein said magnetic storage cell and said logic gate are electrically conductive connected by means of at least one electrically conductive connection **560.**

**Fig. 5B** shows a schematic cross-section of an embodiment **500B** of devices according to the claimed invention in this present application. The embodiment **500B** of devices comprises at least an electronic assembly **510** comprising at least one magnetic storage cell **520** and at least one logic gate, wherein said magnetic storage cell and said logic gate are electrically conductive connected by means of at least one electrically conductive connection **560.** Furthermore, embodiment **500B** comprises at least one testing device **530** with at least one read write electronic **540.**

**Fig. 6** shows a zoomed out schematic cross-section of an embodiment of a device to carry out the method according to one of the claims. In other words, Fig. 6 shows a zoom-out picture of the below described Fig. 8. Fig. 8 represents the diagram for a single flip-flop, whereas Fig. 6 represents the full chip where several flip-flops are placed. Therefore, some of the terminologies which we have used for Fig. 6 is also interchangeable with other figures. Fig. 6 describes the testing method according to the claimed invention in this present application at chip-level. As conventional testing method, it consists of a magnetic probes **610,** several probing pins **620** and the design under test **630.** During the testing, probing knobs (e.g. pins) are adjusted on one of the MTJs of each flip-flops **640,** which are analogous to **200A, 200B,** and **200C,** as described below in Fig. 8. Once these are adjusted, the value to be stored is activated through the probing pins **620** that are programed through the magnetic probe station. Thereafter, in the similar way, the opposite value has to be stored in the other MTJ cell of the each flip-flops **640.** The rest of the sequence of the operation is as explained in the following Fig. 7.

**Fig. 7** shows a schematic flowchart of an embodiment **700** of a method according to one of the claims. The method represented by the embodiment **700** is described as follows:

In step **710** the magnetic probes are configured to perform subsequently a testing method according to one of the claims. In step **720** values for respective MTJs of corresponding flip-flops are set or written. In step **730** the clock is triggered to access CMOS logic. In step **740** the respective value is propagated to next flip-flop. In step **750** the respective values are read from MTJs using magnetic probe. The steps **710** to **750** may be repeated one or more times. Subsequently, i.e. in step **760,** the respective value will be compared with the golden data, i.e. a default value or set of values or data. One of two results are feasible from step **760.** In case of a mismatch between respective value and golden data the test is deemed to be failed - **760.** In case of a match between respective value and golden data the test is deemed to be passed.

**Fig. 8** shows a schematic representation of an embodiment **800** of an exemplary device to carry out the method according to one of the claims 1 to 3. A magnetic probe or magnetic probe system 810 with exemplary two probing pins **620,** whereas such a magnetic probe **610** may provide one or more probing pins **620.** The probing pins **620** are arranged over a corresponding magnetic layer **830,** whereas the magnetic layer **830,** is the layer of the fabrication process in which MTJ cells are fabricated and comprises different processes and materials compared to common process layers, wherein all the MTJ cell are fabricated in the magnetic layer, is here formed exemplary by or comprises two exemplary MTJs. The magnetic layer **830** is electrical conductive connected with at least two write components **204,** i.e. each with one of the respective MTJs of the magnetic layer **830,** and with at least a read component **202.** Further the write components **204** and the read component **202** are electrical conductive connected with at least one conventional flip-flop **850,** respectively, whereas the flip-flop **850** is arranged on top of a so-called CMOS layer **840.** All the CMOS components are fabricated in this CMOS layer **840.** These have certain standard processes for the fabrications and in order to separate it from magnetic layers (in which MTJs are placed).

**Table of reference signs:**

| | |
|---|---|
| **100A** | Basic test method |
| **102** | Test vector |
| **104** | Design under test |
| **106** | Analysis |
| **108** | Inputs |
| **110** | Outputs |
| **112** | Results |
| **100B** | Flip-flop and scan-chain flip-flop structure |
| **114** | Data input |
| **116** | Clk (= Clock) |
| **118** | Arrow represents "replaced with" |
| **120** | Test input |
| **122** | Test enable |
| **124** | Mux |
| **126** | Flip-flop |
| **128** | Q or Test output |
| **100C** | Embodiment of a conventional scan-chain method |
| **130** | Combinational logic |
| **200A** | Non-volatile latch |
| **202** | Read component |
| **204** | Write component |
| **206** | Magnetic tunnel junction (MTJ) |
| **208** | Data |
| **210** | MTJ_read |
| **200B** | Shadow flip-flop architecture acc. to [2] |
| **212** | Data |
| **214** | PD |
| **216** | Conventional CMOS flip-flop |
| **218** | Master latch |
| **220** | Slave latch |
| **222** | Non-volatile latch |
| **200C** | Non-shadow flip-flop architecture acc. to [3] |
| **300** | Embodiment of a method according to claim 1 |
| **310** | First method step according to claim 1 or 3 |
| **320** | Second method step according to claim 1 or 3 |
| **330** | Third method step according to claim 1 |
| **340** | Fourth method step according to claim 1 |
| **400** | Embodiment of a method according to claim 3 |
| **430** | Third method step according to claim 3 |
| **435** | Fourth method step according to claim 3 |
| **440** | Fifth method step according to claim 3 |
| **500A** | Embodiment of an electronic assembly according to claims 2 or 3 |
| **500B** | Embodiment of an electronic assembly and a testing device according to claims 2 or 3 |
| **510** | Electronic assembly |
| **520** | Magnetic storage cell |
| **530** | Testing device |
| **540** | Read write electronic |
| **550** | Logic gate |
| **560** | Electrically conductive connection |
| **600** | Schematic embodiment of a method acc. to one of the claims 1 to 3 |
| **610** | Magnetic probes |
| **620** | Probing pin |
| **630** | Design under test (DUT), e.g. Chip |
| **640** | Flip-flops using MTJ cell |
| **700** | Flow-chart of an embodiment of a method according to one of the claims 1 to 3 |
| **710** | Configuring magnetic probes |
| **720** | Setting values for MTJs of corresponding flip-flops using magnetic probes |
| **730** | Triggering clock to access CMOS logic |
| **740** | Propagating value to next flip-flop |
| **750** | Reading values from MTJs using magnetic probes |
| **760** | Comparing the value with golden data |
| **765** | Mismatch |
| **770** | Failing |
| **775** | Match |
| **780** | Pass |
| **800** | Schematic Embodiment to demonstrate accessing MTJ's using magnetic probes |
| **830** | Magnetic layer |
| **840** | CMOS layer |
| **850** | Conventional flip-flop |

## Claims

1. Method **(300, 400)** for testing at least one electronic assembly **(510),** comprising:
a. Providing:
i. at least one electronic assembly **(510),**
1. wherein said electronic assembly comprises at least n magnetic storage cells **(520),**
and
2. wherein n is a natural number starting with 1, corresponding to positive integers,
i.e. n = 1, 2, 3, ...;
and
ii. at least one testing device **(530)** with n read-write electronics **(540),**
1. wherein said read-write electronics **(540)** are adapted to said at least one said storage cell **(520)** - **(310);**
**b.** Arranging said testing device **(330)** above said electronic assembly **(510)** so that each of said read-write electronics **(440)** is located without contact on top of one respective storage cell **(520)** - **(320);**
**c.** Writing at least one of said storage cells **(520)** by means of said testing device **(530)** - **(330);**
**d.** Triggering subsequently said electronic assembly **(510)** to operate for at least one single system clock pulse;
and
e. Reading out at least said storage cell **(320)** by means of said testing device **(530)** - **(340).**

2. Method **(300, 400)** according to claim 1,
a. wherein said electronic assembly **(510)** further comprises at least m logic gates **(550),**
i. wherein m is a natural number starting with 0, corresponding to non-negative integers,
i.e. m = 0, 1, 2, 3, ...;
and
b. wherein at least one of said magnetic storage cells **(520)** and one of said logic gates **(550)** provides at least one electrically conductive connection **(560).**

3. Method **(400)** according to claim 2, further comprises:
a. writing all said magnetic storage cells by means of said testing device with a first test data set - **(430);**
b. triggering subsequently said electronic assembly to operate for at least one single system clock pulse - **(435);**
and
c. reading out subsequently all said magnetic storage cells by means of said testing device - **(440).**

## Patentansprüche

1. Verfahren (300, 400) zum Prüfen mindestens einer elektronischen Anordnung (510), umfassend:
a. Bereitstellen:
i. mindestens einer elektronischen Anordnung (510),
1. wobei die mindestens eine elektronische Anordnung (510) mindestens n magnetische Speicherzellen (520) umfasst,
und
2. wobei n eine natürliche Zahl ist, die bei 1 beginnt und positiven ganzen Zahlen entspricht, d.h. n = 1, 2, 3, ...;
und
ii. mindestens eine Prüfvorrichtung (530) mit n Lese-Schreib-Elektronik (540),
1. wobei die elektronischen Lese-Schreib-Elektronik (540) an die mindestens eine magnetische Speicherzelle (520) angepasst ist - (310);
b. Anordnen der Prüfvorrichtung (530) derart über der elektronischen Anordnung, dass sich jede Lese-Schreibelektronik (540) berührungslos oberhalb einer entsprechenden Speicherzelle (520) befindet - (320);
c. Beschreiben mindestens einer der Speicherzellen (320) mittels der Prüfvorrichtung (530) - (330);
d. Anschließendes in Betrieb nehmen der elektronischen Anordnung (510) für mindestens einen einzelnen Systemtakt;
und
e. Auslesen mindestens der einen Speicherzelle (320) mittels der Prüfeinrichtung (530) - (340).

2. Verfahren (300, 400) nach Anspruch 1,
a. wobei die elektronische Anordnung (510) ferner mindestens m logische Gatter (550) umfasst,
i. wobei m eine natürliche Zahl ist, die mit 0 beginnt und nichtnegativen ganzen Zahlen entspricht, d.h. m = O, 1, 2, 3, ...;
und
ii. wobei mindestens eine der magnetischen Speicherzellen (520) und eines der Logikgatter (550) mindestens eine elektrisch leitende Verbindung (560) bereitstellt.

3. Verfahren (400) nach Anspruch 2, das ferner umfasst:
a. Beschreiben aller magnetischen Speicherzellen mittels der Prüfvorrichtung mit einem ersten Prüfdatensatz - (430);
b. Anschließendes Auslösen der elektronischen Anordnung zum Betrieb für mindestens einen einzigen Systemtakt - (435);
und
c. Anschließendes Auslesen aller magnetischen Speicherzellen mittels der Prüfvorrichtung - (440).

## Revendications

1. Procédé **(300, 400)** pour tester au moins un assemblage électronique **(510),** comprenant :
a. fournir :
i. au moins un assemblage électronique **(510),**
1. ledit au moins un assemblage électronique comprenant au moins n cellules de mémoire magnétique **(520),**
et
2. n étant un nombre naturel commençant par à 1, correspondant aux entiers positifs,
i.e. n = 1, 2, 3, ... ;
et
ii. au moins un dispositif de test **(530)** avec n éléments électroniques de lecture/écriture **(540),**
1. lesdits éléments électroniques de lecture/écriture **(540)** étant adaptés à ladite au moins une cellule de mémoire **(520)** - **(310)** ;
b. arranger ledit dispositif de test **(530)** sur ledit assemblage électronique **(510)** de manière à ce que chacun desdits éléments électroniques de lecture/écriture soit placé sans contact au-dessus de la cellule de mémoire respective **(520)** - **(320)** ;
c. écrire dans au moins une desdites cellules de mémoire **(520)** par le biais dudit dispositif de test **(530)** - **(330)** ;
d. déclencher ensuite ledit assemblage électronique **(510)** pour opérer pendant au moins une seule pulsation d'horloge système ;
et
e. lire au moins ladite cellule de mémoire **(320)** par le biais dudit dispositif de test **(530)** - **(340).**

2. Procédé **(300, 400)** selon la revendication 1,
a. ledit assemblage électronique **(510)** comprenant en outre au moins m portes logiques **(550),**
i. m étant un nombre naturel commençant par 0, correspondant aux entiers non-négatifs,
i.e. m = 0, 1, 2, 3, ... ;
et
ii. au moins l'une desdites cellules de mémoire magnétique **(520)** et l'une desdites portes logiques **(550)** fournit au moins une connexion électriquement conductrice **(560).**

3. Procédé **(400)** selon la revendication 2, comprenant en outre :
a. écrire dans toutes lesdites cellules de mémoire magnétique par le biais dudit dispositif de test avec un premier set de données test - **(430)** ;
b. déclencher ensuite ledit assemblage électronique pour opérer pendant au moins une seule pulsation d'horloge système - **(435)** ;
et
c. lire ensuite toutes les cellules de mémoire magnétique par le biais dudit dispositif de test - **(440).**
